Europäisches Patentamt

European Patent Office

Office européen des brevets

(11) Publication number: **0 337 656**
**A2**

## (12) EUROPEAN PATENT APPLICATION

(21) Application number: 89303379.5

(22) Date of filing: 05.04.89

(51) Int. Cl.⁴: **H01Q 9/00 , H01L 39/14**

(30) Priority: 12.04.88 GB 8808618

(43) Date of publication of application:
18.10.89 Bulletin 89/42

(84) Designated Contracting States:
**AT BE CH DE ES FR GB IT LI LU NL SE**

(71) Applicant: **IMPERIAL CHEMICAL INDUSTRIES PLC**
**Imperial Chemical House Millbank**
**London SW1P 3JF(GB)**

(72) Inventor: **Alford, Neil McNeil**
**49a Daleside**
**Upton Chester(GB)**
Inventor: **Harmer, Mark Andrew**
**823 Windsor Street**
**Wilmington Delaware 19801(US)**
Inventor: **Maclean, Thomas S.M.**
**33 Kelmscott Road**
**Harborne Birmingham B17 8QW(GB)**
Inventor: **Gough, Colin E.**
**44 School Road**
**Moseley Birmingham B13 9SN(GB)**
Inventor: **Khamas, Salam**
**Iraq Baghdad New Baghdad**
**Hay Summer M706 Z16 D53(IQ)**
Inventor: **Mehler, Michael J.**
**55 Woodthorpe Drive Bewdley**
**Hereford & Worcester DY12 2RH(GB)**

(74) Representative: **Walmsley, David Arthur Gregson et al**
**Imperial Chemical Industries PLC Legal department: Patents PO Box 6 Bessemer Road**
**Welwyn Garden City Hertfordshire AL7 1HD(GB)**

(54) **High efficiency antenna.**

(57) A shaped article having a shape suitable for use as an antenna in which the material from which the antenna is constructed becomes electrically superconducting at a temperature which is not lower than the temperature at which liquid nitrogen boils.

The material may be a ceramic material, for example an oxide material, eg $YBa_2Cu_3O_x$ where x is between 6.5 and 7.2

*Fig.1.*

# HIGH EFFICIENCY ANTENNA

This invention relates to an antenna, and in particular to a high efficiency electrically short dipole antenna, and also to loop antennae, closed helical antennae and open helical antennae.

In many practical applications wire antennae are constrained so as to be of small dimensions when compared with the wavelength. However, for such electrically short antennae the ohmic losses can be substantial, and specifically they can be larger than, and sometimes considerably larger than, the radiation resistance. The efficiency of such antennae is generally low.

The aforementioned ohmic losses can be very much reduced by operating an antenna at low temperature, for example, by cooling the antenna to the temperature of liquid nitrogen, that is to a temperature of -196°C at which liquid nitrogen boils, and especially by cooling the antenna to the temperature of liquid helium, that is to a temperature of -269°C at which liquid helium boils. Thus, a significant increase in radiation efficiency can be achieved by operating a copper antenna at the temperature at which liquid nitrogen boils and particularly by operating an antenna of electrically superconducting material at the temperature at which liquid helium boils.

The present invention relates to the inventors' finding that, by selection of the material from which the antenna is constructed, it has been possible to construct an antenna of high efficiency, for example an electrically short dipole antenna of high efficiency, without the need to undergo the inconvenience and expense of operating at a temperature at which liquid helium boils. The material from which the antenna is constructed is electrically superconducting and the efficiency of the antenna is enhanced by operating at a temperature at which the material of construction of the antenna is superconducting, that is by operating at a temperature below the critical temperature of the superconducting material. In one embodiment the material from which the antenna of the invention is constructed becomes superconducting at a temperature which is not lower than the temperature at which liquid nitrogen boils, and possibly at a higher temperature, and the invention in one embodiment thereof thus provides a shaped article having a shape suitable for use as an antenna, particularly a high efficiency electrically short dipole antenna, in which the material from which the antenna is constructed becomes electrically superconducting at a temperature which is not lower than the temperature at which liquid nitrogen boils and which in operation thus requires the provision only of the relatively inexpensive liquid nitrogen rather than the very much more expensive liquid helium. The antenna is substantially more efficient than is a copper antenna operated at the temperature at which liquid nitrogen boils.

The phenomenon of electrical superconductivity has been known for many years but until very recently such superconductivity could be obtained, for example in a niobium alloy, e.g. in a niobium-tin alloy, only at the extremely low temperatures attainable with liquid helium.

In a more recent development the phenomenon of superconductivity has been observed in certain non-metallic materials and at substantially higher temperatures than those at which superconductivity has been observed hitherto. In particular, the phenomenon of superconductivity has been observed in certain non-metallic materials at temperatures as high as -196°C, or even higher, that is at temperatures which are attainable by cooling with liquid nitrogen. These recently developed materials are ceramic materials which are relatively easy to make and are relatively inexpensive.

In Z. Phys. B. - Condensed Matter, 64, pp 189-193 (1986) J. G. Bednorz and K. A. Muller reported the preparation of coprecipitated and heat treated mixtures of lanthanum, barium, copper and oxygen and they reported that the mixtures showed superconductivity at a critical temperature higher than the critical temperatures which had been observed hitherto for metals and alloys. The mixtures were reported to have a composition $La_{5-x}Ba_xCU_5O_{5(3-y)}$ where $x = 0.75$ to 1 and $Y > O$, and the compositions were prepared by coprecipitation from barium-, lanthanum- and copper nitrate solutions by addition to an oxalic acid solution followed by decomposition and solid state reaction at 900°C for 5 hours and sintering in an oxygen atmosphere.

In published European Patent Application 0 275 343 there is described a superconductive compound having a critical temperature above 28°K, and which may be as high as 35°K. The compound is of the $RE_2TMO_4$ type wherein the rare earth element (RE) is partially substituted by one or more alkaline earth metal elements (AE) and wherein the oxygen content is adjusted such that the resulting crystal structure is distorted and comprises a phase of the general composition $RE_{2-x}AE_xTMO_{4-y}$, wherein TM represents a transition metal and $x < 0.3$ and $y < 0.5$. A favoured rare earth element is lanthanum, a favoured alkaline earth element is barium, and a favoured transition metal is copper.

In International Patent Application No PCT/US 87/02958, International Publication No WO 88/05029, there is described a composition which is superconducting at a temperature of 40°K and higher, and which comprises a sintered metal oxide complex of the formula

$[L_{1-x}M_x]_aA_bO_y$

in which L is yttrium, lanthanum, cerium, preasodymium, neodymium, samarium, europium, gadolinium, terbium, dysprosium, holmium, erbium, thulium, ytterbium, or lutetium, or a combination thereof, M is barium, strontium, calcium, magnesium, mercury, or a combination thereof provided that when L is lanthanum M is not barium, A is copper, bismuth, tungsten, zirconium, tantalum, niobium, or vanadium, x is from about 0.01 to 1.0, a is 1 to 2, b is 1, and y is about 2 to 4.

In the aforementioned International Publication there is also described the production of the sintered metal oxide complex by heating a mixture of solid compounds containing L, M, A and 0 in proportions appropriate to yield the aforementioned formula to a temperature of 640-800°C in an oxygen atmosphere and for a time sufficient to react the mixture in the solid state and then heating the mixture at 900-1100°C for a period of at least about 12 hours subsequent to the reaction, pelletizing the mixture, and sintering the pellets. With certain of the sintered metal oxide complexes a critical temperature as high as 100°K, that is - 173°C, has been observed. A preferred sintered metal oxide complex is that in which L is yttrium, M is barium, and A is copper and one phase of such a preferred material which has been identified as having a high critical temperature is that having an empirical formula $YBa_2Cu_3O_x$ where x is typically between 6.5 and 7.2. Other examples of ceramic oxide super conducting materials which have a high critical temperature include (Bi,Pb)Sr Ca Cu oxide, eg $(Bi,Pb)_2Sr_2Ca_2Cu_3Ox$, and Tl Ba Ca Cu oxide, eg $Tl_2Ba_2CaCu_3Ox$.

Merely by way of example, and to illustrate the ease of production, the production of an yttrium-barium-copper oxide ceramic material will be described. A suitable yttrium-barium-copper oxide is that having the composition $YBa_2Cu_3O_x$ where x is betwen 6.5 and 7.2. Such a ceramic superconducting material may be produced by forming a mixture of the oxides of the required elements, and/or of precursors for these oxides, eg carbonates, in the required proportions, heating the mixture at an elevated temperature in an oxygen-containing atmosphere, eg at a temperature of 900 to 950°C or higher in air, for a time which is of the order of 12 to 24 hours, and subsequently cooling the thus formed ceramic material. The thus formed ceramic superconducting material may be in the form of a sintered structure which, if desired, may be ground in order to convert the material into a particulate form which is suitable for shaping into the form of an antenna.

The invention thus also provides a shaped article having a shape suitable for use as an antenna, particularly a high-efficiency electrically short dipole antenna, in which the article, hereinafter referred to as the antenna, comprises a ceramic electrically superconducting material.

The ceramic superconducting material may be any material which has superconducting properties, but preferably, and for the reasons explained hereinbefore, it is such a material which becomes electrically superconducting at a temperature which is not lower than that at which liquid nitrogen boils. Suitable such materials are ceramic oxides, eg an yttrium-barium-copper oxide having the composition $YBa_2Cu_3Ox$ where x is between 6.5 and 7.2

In the antenna the particles of ceramic superconducting material are preferably in the form of a sintered structure as in an antenna sintering of the particles results in greater structural integrity of the antenna.

The antenna may be in the form of a shaped wire. Such a shaped wire may be produced from the particulate ceramic superconducting material, or from precursors therefore, by processes which are conventional in the ceramics processing art, for example, by powder pressing or by isostatic pressing. For example, the particulate ceramic superconducting material, or precursors therefore, may be pressed in a mould into a desired shape at elevated pressure and heated at elevated temperature in an oxygen-containing atmosphere, e.g. in air at a temperature of the order of 900 to 950°C or higher, in order to sinter together the particles of ceramic superconducting material, or to convert the precursors to ceramic superconducting material and to sinter the particles. The thus sintered particles in the form of a wire may be cooled slowly to ambient temperature in an oxygen-containing atmosphere, and during the cooling process the wire may be annealed, for example at a temperature of approximately 400°C to 450°C. In an alternative process, which is very much preferred as it is may be operated to produce wire of considerable length which may readily be shaped into antennae having a variety of different shapes, the wire may be formed by shaping, eg extruding, a composition which comprises the particulate ceramic superconducting material, or precursors therefor, a liquid, and an organic material which is soluble in or dispersible in the liquid, the wire may be formed into any desired shape, and the organic material removed from the thus shaped wire by heating at elevated temperature. Thereafter, the particles of ceramic superconducting material may be sintered, or the precursors may be converted to ceramic superconducting material and sintered, and the wire may be cooled following the procedure hereinbefore described. Suitably, shaping of a composition comprising particulate superconducting material, or precursors therefor, and an organic material is effected by extruding the composition. The organic material may be an organic polymeric material, and the composition preferably comprises a solution of an organic polymeric material in a liquid solvent as such compositions are generally easily shaped into the desired shape of the antenna.

The shape and dimensions of the antenna which may be in the form of a wire may vary. For example, the wire may have a thickness of a few tens of microns to several thousand microns, e.g. from 50 microns to 5000 microns, although these thicknesses are meant to be by way of example and are not limiting. The antenna may be a monopole antenna or a dipole antenna, eg it may comprise a pair of elongated limbs connected by a relatively short bridge piece, or it may be a loop, or it may have a helical shape, which may be open or closed.

The antenna is not necessarily in the form of a wire. For example, it may be in the form of a strip on an inert substrate, that is on a substrate which is not electrically conducting, e.g. a film deposited on such a substrate. A composition which comprises the particulate ceramic superconducting material, or precursors therefor, a liquid, and an organic material may be applied in a shape of the ultimately desired antenna to an inert substrate, and the organic material may be removed from the deposited composition by heating at elevated temperature. Thereafter the particles of ceramic superconducting material may be sintered, or the precursors may be converted to ceramic superconducting material and sintered, and the thus formed antenna may be cooled following the procedure hereinbefore described.

The antenna may be adapted to operate at different frequencies merely by changing the shape of the antenna, and the antenna may form part of an array comprising a plurality of antennae.

The invention will now be described with the aid of the following example.

## Example 1

A particulate mixture of $BaCO_3$, $CuO$ and $Y_3O_3$ in proportions by weight of 52.9:32.0:15.1 was charged to a plastic container together with ethanol and the mixture was mixed and ground on a vibro energy mill using zirconia as a grinding medium. The mixture was removed from the plastic container and dried on a rotary evaporator and then heated in a furnace in an atmosphere of air at a temperature of $900°C$ for 12 hours. The mixture was then removed from the furnace and reground using the above-described procedure until the resulting particulate material had a surface area as measured by the BET method in the range 1 to 6 $m^2g^{-1}$. The particulate material had a particle size in the range 0.001 to 5 micrometres and had a composition, as determined by X-ray diffraction, of $YBa_2Cu_3O_x$.

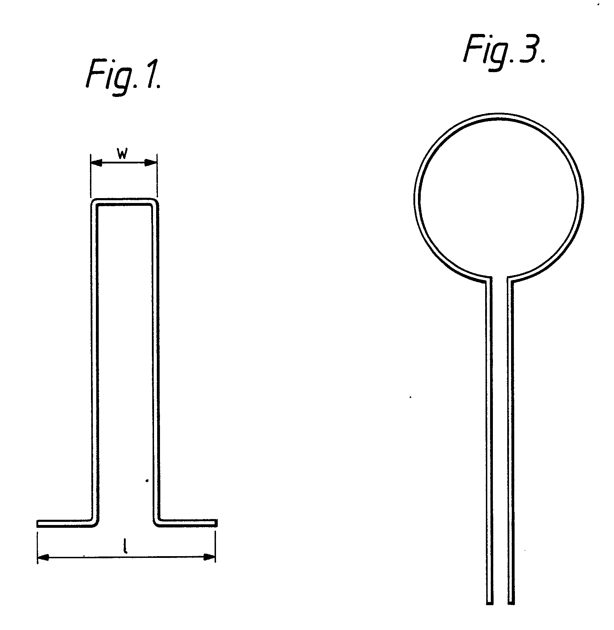

100 parts by weight of the particulate material was mixed with 7 parts by weight of polyvinyl butyral/alcohol copolymer and with 10.5 parts by weight of cyclohexanone, and the viscous composition was passed repeatedly through the nip between the rolls of a twin-roll mill at ambient temperature. The composition, which adhered to one of the rolls of the mill, was repeatedly removed from the roll, turned at right angles, and passed back through the nip in order to produce a homogeneously mixed composition. During the mixing procedure on the twin-roll mill some of the cyclohexanone evaporated. The sheet which was produced on the twin-roll mill was removed from the mill, chopped into small pieces, charged to a ram extruder, and extruded in the form of a 1 mm diameter wire which was then shaped into the shape of an antenna as shown in the accompanying Figure 1. The antenna was then heated in an oven at $80°C$ to evaporate the cyclohexanone, then at $450°C$ for 1 hour to burn off the polyvinyl butyral/alcohol copolymer, and finally the antenna was heated in an atmosphere of oxygen at $920°C$ for 10 hours to sinter the particles of superconducting material and the oven and contents were then cooled to $400°C$ in an atmosphere of oxygen at a rate of $1°C$ per minute. The temperature of the oven was maintained at $400°C$ for 10 hours and then it was cooled to ambient temperature at a rate of $1°C$ per minute. Thermogratimetric analysis indicated that in the composition $YBa_2Cu_3Ox$, x had a value of 6.9.

The antenna had a line spacing W of 4 mm and a dipole length 1 of 20 mm (see Figure 1).

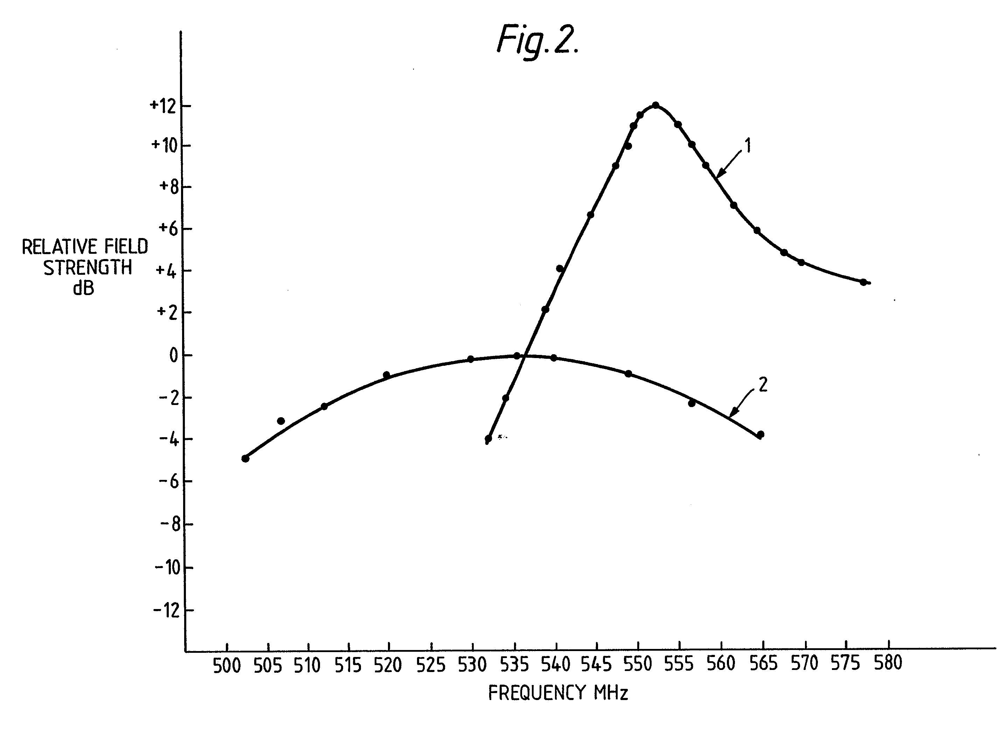

The measured relative field strength of the antenna operated at the temperature of liquid nitrogen, as a function of frequency, is shown in Figure 2 (line 1), together with the measured field strength of a copper antenna operated at $20°C$ (line 2).

## Example 2

The procedure of Example 1 was repeated except that the 1 mm diameter extruded wire was shaped into the form of loop antenna which was thereafter heated following the procedure of Example 1. The loop, which is shown in Figure 3, had a diameter of 5 cm and he legs attached to the loop each had a length of 20 cm.

The loop antenna was operated at 470 MHz and at a temperature of 77K and showed a 10 dB gain over an identically-shaped copper antenna when operated at both 300K and at 77K.

## Claims

1. A shaped article having a shape suitable for use as an antenna in which the material from which the antenna is constructed becomes electrically superconducting at a temperature which is not lower than the temperature at which liquid nitrogen boils.

2. A shaped article as claimed in claim 1 having a shape suitable for use as a high efficiency electrically short dipole antenna.

3. A shaped article as claimed in claim 1 having a shape in the form of a loop, a closed helix or open helix and suitable for use as a high efficiency antenna.

4. A shaped article having a shape suitable for use as an antenna in which the article comprises a ceramic electrically superconducting material.

5. A shaped article as claimed in claim 4 having a shape suitable for use as a high efficiency electrically short dipole antenna.

6. A shaped article as claimed in claim 4 having a shape in the form of a loop, a closed helix or open helix and suitable for use as a high efficiency antenna.

7. A shaped article as claimed in any one of claims 4 to 6 in which the ceramic material has a critical temperature which is not lower than the temperature at which liquid nitrogen boils.

8. A shaped article as claimed in any one of claims 1 to 7 in which the electrically superconducting material comprises a ceramic oxide.

9. A shaped article as claimed in claim 8 in which the ceramic oxide has a composition $Y Ba_2 Cu_3 O_x$ where x is between 6.5 and 7.2

10. A shaped article as claimed in any one of claims 4 to 9 in which the particles of ceramic electrically superconducting material are sintered.

11. A shaped article as claimed in any one of claims 1 to 10 which is in the form of a shaped wire.

12. A shaped article as claimed in claim 11 in which the wire has a thickness in the range 50 microns to 5000 microns.

13. A shaped article as claimed in any one of claims 1 to 10 which is in the form of a strip on a substrate which is not electrically conducting.

14. A shaped article as claimed in any one of claims 4 to 13 which is formed from a composition which comprises particulate ceramic superconducting material, a liquid, and an organic material which is soluble in or dispersible in the liquid.

15. A shaped article as claimed in claim 14 in which organic material is an organic polymeric material.

16. A shaped article as claimed in claim 14 or claim 15 which is produced by shaping the composition, heating the shaped composition at elevated temperature to remove the organic material therefrom, and heating the shaped composition to sinter the particle of ceramic superconducting material.

17. An array comprising a plurality of shaped articles suitable for use as antennae and as claimed in any one of claims 1 to 16.

# Fig. 1.

w

l

# Fig. 3.

*Fig.2.*

EP 0 337 656 A2